# EUROPEAN PATENT SPECIFICATION

(11) **EP 3 333 878 B1**
(45) Date of publication and mention of the grant of the patent: **23.10.2019**
(21) Application number: 17206077.4
(22) Date of filing: 08.12.2017
(51) Int. Cl.: H01J 37/305, H01J 37/077, H01J 37/147, C22B 9/22

(54) **GAS-DISCHARGE ELECTRON GUN**
GASENTLADUNGSELEKTRONENKANONE
CANON À ÉLECTRONS À DÉCHARGE DE GAZ

(30) Priority: 09.12.2016 LV 160098
(43) Date of publication of application: 13.06.2018
(73) Proprietor: SIA "KEPP EU", 1034 Riga (LV)
(72) Inventor: Ivanovs, Vadims, 1019 Riga (LV); Kravtsov, Anatoly, 1011 Riga (LV); Ladohin, Sergej, 01034 Kyiv (UA)
(74) Representative: Zaboliene, Reda

(56) References cited:
- CN-A- 105 590 816
- CN-U- 205 428 866
- SU-A1- 1 112 437
- UA-C2- 93 625
- UA-U- 83 313

## Description

### THE FIELD OF THE INVENTION

The invention relates to electronic equipment, more specifically - to development of gas-discharge electron guns for processing applications and can be used in special electrometallurgy for equipping high-capacity electron beam melting facilities, designed for melting and casting of metals and alloys for various purposes, especially for conducting the process with electromagnetic stirring (EMS) of the melt both for alloy smelting and forming of ingots or cast billets.

The feature of technological process with EMS is in the need of placing the electron beam gun and melting crucible or mould cup on a same vertical axis in order to exclude deviations of the electron beam from the heating zone influenced by electromagnetic fields generated by EMS system. However, such gun placement makes its operating conditions more complex, since the main structural elements of the gun are along the line of sight of the heated surface, making them susceptible to gases, metal vapours and even splashes, and also causing overheating of these elements due to thermal radiation from the heated surface. In such operating circumstances, in place of traditional axial guns with thermionic cathodes, it turns out to be appropriate to use high-voltage glow discharge guns, often also called cold cathode guns, a main feature of which is that their basic structural elements are cooled with water and cathodic anode area supports higher pressure of gases than the processing chamber [ 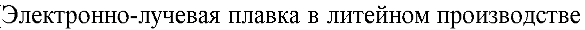 (Electron beam melting in foundry production) / Edited by S.V. Ladohin. - Kiev: Publishing Company "Steel", 2007. - Pages 102-107.].

### The background of the invention and prior art

High-voltage glow gas discharge guns are known, which operation is based on the use of electrical discharge between cold electrodes in low-pressure gas medium [ 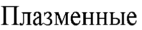 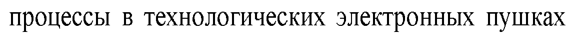 (Plasma processes in the processing electron guns) / M.A. Zavyalov, Y.E. Kreyndel, A.A. Novikov, L.P. Shanturin. - M.: Energoatomizdat, 1989. - Pages 97-145.]. The main design elements in these guns are: cathode node with electron emitter, anode node with a transparent electrode for the passage of the electron beam, a working gas supply system, an electrode cooling system, a beam guide with beam focusing and deflection systems on its way into the processing chamber. In these guns, a flow of electrons forms as a result of the bombing of the cathode surface with positively charged ions that emerge due to accelerating and recharging of ions in the potential's cathode fall space, as well as by fast atoms of working gas. Regeneration and acceleration of electrons occurs within discharge due to high voltage supplied between anode and cathode. The resulting beam of electrons enters the processing chamber heading to the heated surface through the beam guide with the beam focusing and deflection systems.

The drawback of the gun is gas penetrating into the processing chamber from the cathode-anode area of the gun, and pressure of such gas in this area is higher than the pressure of residual gases in the processing chamber and cathode and anode atoms of metal, which are also penetrate into the atmosphere of cathode-anode area to some extent due to the bombardment noted above. This leads to the possibility of mentioned gas atoms and metal from the structural elements of the gun penetrating into the melt alloy or purified metal.

One more gas-discharge electron beam gun is also known, which consists of a sealed metal casing that hosts high-voltage insulator, cold concave cathode with an extended emitting surface and coaxial hollow anode with a bottom part designed in the shape of a plate with channels for cooling water and holes for the passage of the electron beam, a working gas supply system and an electrode cooling system, as well as a beam guide, attached to the casing coaxially to anode, equipped with focusing and deflecting coils. Cooling water channels are made inside the plate's casing and linked between each other forming a single system, located around the opening for the beam's passage. The cooling system is made of four channels connected in the shape of a square or rectangle, with each channel made with the ability to exit the sealed metal housing and is equipped with a replaceable tight cap [UA83514 (C2), published 2008-07-25].

Despite the significantly more efficient cooling compared to other known high-voltage glow discharge guns, this gun has the same downside as one discussed above, namely the penetration of gas and atoms of metal from the gun's structural elements into the processing chamber, and therefore potentially into the melt alloy or purified metal.

Also known a gas-discharge electron beam gun chosen as a prototype, which consists of a sealed metal casing that hosts high-voltage insulator, cold concave cathode with an extended emitting surface, coaxial hollow anode, with a bottom part designed in the shape of a plate with channels for cooling water, which are made within the casing of the plate and linked between each other forming a single system located around the opening for the passage of the electron beam, a beam guide hermetically attached to the casing and equipped with focusing and deflecting coils, which is made of two parts in the shape of a bend, with the first part attached to the metal casing while the second part is made with the possibility of joining with the processing chamber; the turn angle of the second part of the beam guide in respect the first one is designed as to exclude direct passing of the electron beam through the opening in anode to the crucible, which is located in the centre of the attached processing chamber, so focusing coils are located on the first part of the beam guide, and the second part thereof features beam turning coils to the turn angle of the second part of the beam guide, and beam deflection coils [UA93625 (C2), published 2011-02-25].

The disadvantage of this gun remain as in the aforementioned cases - the possibility of intrusion of gas and metal atoms from the structural elements of the gun into the processing chamber, which may occur despite the existence of the beam guide's bend.

### Summary of the invention

The basis for the invention is the desire to exclude ingress of metal atoms of the gun's structural elements into the processing chamber. A gas-discharge electron beam gun is proposed for this task, consisting of a sealed metal casing that hosts high-voltage insulator, cold concave cathode with an extended emitting surface, coaxial hollow anode with a bottom part designed in the shape of a plate with channels for cooling water, which are executed within the body of the plate and linked between each other forming a single system, located around the hole for the passage of the electron beam, as well as beam guide hermetically attached to the casing and consisting of two parts in the shape of a bend, the first part of which is attached to a metal casing, while the second part is attached to the first part, the angle of rotation of the second part of the beam guide against the first part is chosen to exclude direct passing of the beam through a hole in the anode to the crucible, which is located in the process chamber, and focusing coils are located on the first part of the beam guide, and the second part of it features beam rotation coils by an angle of rotation of the second part of the beam guide where, according to the invention, a second bend is made on the beam guide with the same angle as the first bend, but oppositely directed, and both bends divide the beam guide into three parts, the first of which is hermetically attached to the gun's metal casing, the second is intermediate and the third is arranged such that it can be hermetically attached to the processing chamber, and beam turning coils are located near the bends on the beam guide that turn the beam to an angle equal to the angle of bends, and beam focusing coils and deflection (scanning) coils are respectively located on all three parts.

The essence of the invention is explained by the drawing, where a schematic section of the gas-discharge electron gun is shown.

### Brief description of the drawings

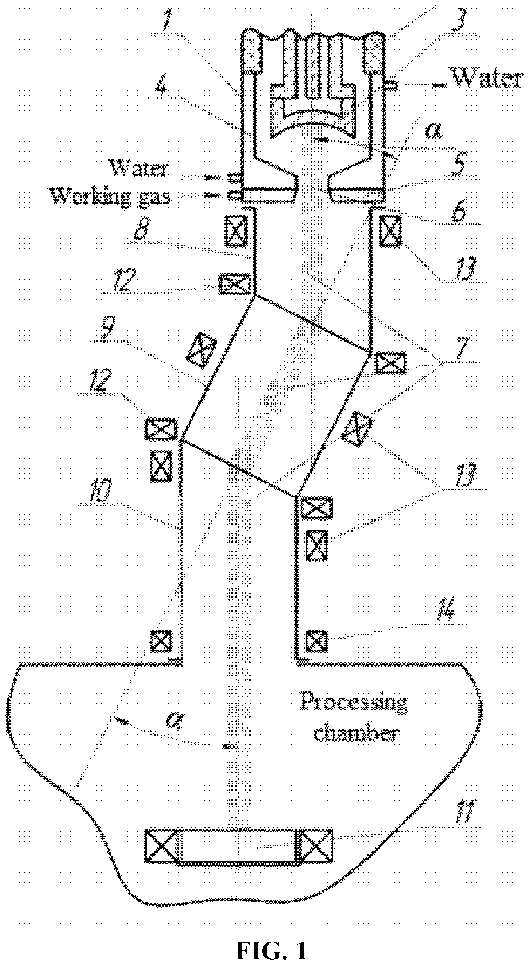

Fig. 1 - section of the gas-discharge electron gun.

### Detailed description of the invention

An insulator (2) is placed in a metal casing (1), to which cathode (3) with extended emitting surface is attached. In the casing (1) coaxially with cathode (3) hollow anode (4) is installed, which bottom part is made in the shape of a plate (5), in which channels for cooling water are made (not shown on the drawing). The channels are made inside the plate (5) and connected to each other forming a single system located around the opening (6) intended for the passage of the electron beam (7). To the casing (1), a beam guide is hermetically attached, designed with two bends that divide it into three parts, one of which (8) is connected to the casing (1), the second one (9) is the intermediate part, and the third one (10) is connected to the processing chamber. The processing chamber features an object (11), which is heated by the electron beam (7) and is located in the same vertical axis with the part (10) of the beam guide, thus eliminating the deflection of the beam from the heating zone affected by electromagnetic fields generated by the object's EMS system (11). Angles of bends (a) between parts (8) and (9), (9) and (10) of the beam guide are equal to each other, but oppositely directed. Beam turning coils (12) that turn the beam to the specified angle (a) are placed near both bends. Focusing coils (13) are located on all three parts of the beam guide, and beam deflection coils (14) are placed on the part (10), which is connected to the processing chamber.

The proposed gas-discharge electron gun operates as follows. After creating required vacuum in the processing chamber, cathode-anode area of the gun is filled with working gas and cathode (3) is supplied with accelerating voltage of 20-30 kV. At a pressure of working gas of about one Pa, glow discharge occurs, which current strength is adjusted by regulating the pressure of working gas, and which causes the formation of the electron beam. This beam enters the part (8) of the beam guide, which is coupled with the casing (1) of the gun, and by help of the focusing coils (13) the beam is forwarded to the bend between the parts (8) and (9) of the beam guide, from where, using the beam turning coils (12), it is firstly directed into the part (9) of the beam guide and then through the bend between the parts (9) and (10) into the part (10) of the beam guide, which is connected to the processing chamber and located on the same vertical axis with the heated object (11). The object's (11) heating process can be adjusted using the coils (14), which provide the formation of the necessary heating configurations of the object's (11) surface.

The advantage of the reviewed gun lies in a guaranteed exclusion of the possible intrusion of the atoms of metal of the gun's structural elements into the processing chamber thanks to the double turn of the electron beam in the beam guide. This will ensure obtaining high-purity metals and/or alloys.

## Claims

1. A gas-discharge electron beam gun, consisting of a sealed metal casing (1) that hosts high-voltage insulator (2), cold concave cathode (3) with an extended emitting surface, coaxial hollow anode (4) with a bottom part designed in the shape of a plate (5) with channels for cooling water, which are executed within the body of the plate and linked between each other forming a single system, located around an opening (6) for the passage of the electron beam (7), as well as beam guide tightly attached to the casing and consisting of two parts in the shape of a bend, the first part (8) of which is attached to the metal casing, while the second part (9) is attached to the first part, the angle of rotation (α) of the second part of the beam guide in respect the first part is chosen to exclude direct passing of the beam through the opening in the anode to a crucible, which is located in a process chamber, and focusing coils are located on the first part of the beam guide, and the second part of it features beam rotation coils by an angle of rotation of the second part of the beam guide, **characterised in that** a second bend is made on the beam guide with the same angle (α) as the first bend, but oppositely directed, and both bends divide the beam guide into three parts, the first (8) of which is hermetically attached to the gun's metal casing, the second (9) is intermediate and the third (10) is arranged such that it can be hermetically attached to the processing chamber, and beam turning coils (12) are located near the bends on the beam guide and are arranged such that they can turn the beam to an angle (α) equal to the angle of bends, and beam focusing coils (13) and deflection scanning coils (14) are respectively located on all three parts.

## Patentansprüche

1. Gasentladungs-Elektronenstrahlkanone, bestehend aus einem abgedichteten Metallgehäuse (1), das einen Hochspannungsisolator (2) aufnimmt, einer konkaven Kaltkathode (3) mit einer verlängerten Emittierfläche,
einer koaxialen Hohlanode (4) mit einem Unterteil, das in Form einer Platte (5) mit Kanälen
für Kühlwasser konstruiert ist, die innerhalb des Körpers der Platte ausgeführt und untereinander verbunden sind und ein einziges System bilden, das sich um eine Öffnung (6) für den Durchgang des
Elektronenstrahls (7) befindet,
sowie einer Strahlführung, die fest an dem Gehäuse angebracht ist und aus zwei Teilen in Form einer Biegung besteht, deren erster Teil (8) an dem Metallgehäuse angebracht ist, während der zweite Teil (9) an dem ersten Teil angebracht ist,
wobei der Drehwinkel (a)
des zweiten Teils der Strahlführung in Bezug auf den ersten Teil gewählt ist, um einen direkten Durchgang des Strahls durch die Öffnung in der Anode zu einem Tiegel ausgeschlossen ist,
der sich in einer Prozesskammer befindet,
und sich Fokussierspulen an dem ersten Teil der Strahlführung befinden, und der zweite Teil davon Strahlrotationsspulen um einen Drehwinkel des zweiten Teils der Strahlführung aufweist,
**dadurch gekennzeichnet, dass** an der Strahlführung eine zweite Biegung mit dem gleichen Winkel (a) wie die erste Biegung, jedoch entgegengesetzt gerichtet, gemacht ist und beide Biegungen die Strahlführung in drei Teile unterteilen, wovon der erste (8)
hermetisch an dem Metallgehäuse der Pistole angebracht ist, der
zweite (9) in der Mitte ist und der dritte (10) angeordnet ist, sodass er hermetisch an der Prozesskammer angebracht werden kann,
und sich Strahldrehspulen (12)
in der Nähe der Biegungen an der Strahlführung befinden und angeordnet sind, sodass sie den Strahl in einen Winkel (a)
drehen können, der gleich dem Winkel der Biegungen ist, und sich Strahlfokussierspulen (13) und Ablenkungs-Scanspulen (14) jeweils an allen drei Teilen befinden.

## Revendications

1. Canon à électrons à décharge gazeuse, constitué d'un boîtier métallique scellé (1) qui reçoit un isolant haute tension (2), d'une cathode concave froide (3) avec une surface émettrice étendue,
d'une anode creuse coaxiale (4) avec une partie inférieure conçue en forme de plaque (5) avec des canaux
pour eau de refroidissement, qui sont exécutés dans le corps de la plaque et reliés entre eux formant un système unique, situé autour d'une ouverture (6) pour le passage du faisceau électronique (7),
ainsi qu'un guide de poutre étroitement fixé au boîtier et constitué de deux parties en forme de coude, dont la première partie (8) est fixée au boîtier métallique,
tandis que la seconde partie (9) est fixée à la première partie,
l'angle de rotation (a)
de la seconde partie du guide de poutre par rapport à la première partie étant choisi pour exclure un passage direct du faisceau dans l'orifice de l'anode vers un creuset, qui est situé dans une
chambre de traitement, et des bobines de focalisation sont situées sur la première partie du guide de faisceau, et la deuxième partie de celui-ci comporte des bobines de rotation de faisceau par un angle de rotation de la deuxième partie du guide de faisceau, **caractérisé en ce qu'**un deuxième coude est réalisé sur le guide de faisceau avec le même angle (α)
**que** le premier coude, mais dirigé en sens inverse, et les deux coudes divisent le guide de faisceau en trois parties, dont le premier (8)
est fixé hermétiquement au boîtier métallique du pistolet, le
second (9) est intermédiaire et le troisième (10) est disposé de manière à pouvoir être fixé hermétiquement à la
chambre de traitement, et des bobines de retournement de faisceau (12) sont situées près des coudes sur le guide de faisceau et sont disposées de manière à pouvoir tourner le faisceau selon un angle (α)
égal à l'angle des coudes, et des bobines de focalisation de faisceau (13) et de balayage par déflection (14) sont respectivement situées sur les trois parties.
